# EUROPÄISCHE PATENTANMELDUNG

(11) **EP 1 876 462 A1**
(43) Veröffentlichungstag der Anmeldung: **09.01.2008**
(21) Anmeldenummer: 07012635.4
(22) Anmeldetag: 28.06.2007
(51) Int. Cl.: G01R 33/383

(54) **Magnetsystem mit variabler Feldstärke**

(30) Priorität: 05.07.2006 DE 102006031425
(71) Anmelder: Forschungszentrum Jülich GmbH, 52425 Jülich (DE); Max-Planck-Institut für Polymerforschung, 55128 Mainz (DE)
(72) Erfinder: Blümler, Peter, 52428 Jülich (DE); Bauer, Christian, 55288 Armsheim (DE); Soltner, Helmut, 52459 Inden (DE); Raich, Hans-Peter, 55597 Gumbsheim (DE); Jeschke, Gunnar, 78467 Konstanz (DE)

(57) **Zusammenfassung**

Die Erfindung betrifft ein Magnetsystem zur Beaufschlagung eines Probenraums mit einem Magnetfeld variabler Stärke. Dieses System umfasst mindestens zwei gegeneinander drehbar gelagerte Stapelungen von Ringen, die magnetisierte Bereiche aufweisen. Die durch die Stapelungen bewirkten Magnetfelder addieren sich an jedem Punkt im Probenraum vektoriell. Somit kann durch eine Drehung der Stapelungen gegeneinander die Magnetfeldverteilung im Probenraum variiert werden. Bei geeigneter Wahl der Abstände zwischen benachbarten Ringen innerhalb einer Stapelung kann das Feld im Probenraum ausreichend homogen ausgestaltet werden, um für Elektronenspinresonanz (ESR)-Untersuchungen von Proben geeignet zu sein. Hauptvorteil des erfindungsgemäßen Systems gegenüber normal- oder supraleitenden Elektromagneten ist, dass es das Magnetfeld mit Permanentmagneten erzeugen kann, die weder eine Kühlung noch eine Energiequelle zur Aufrechterhaltung des Magnetfelds benötigen.

## Beschreibung

Die Erfindung betrifft ein Magnetsystem zur Beaufschlagung eines Probenraums mit einem Magnetfeld variabler Stärke.

### Stand der Technik

In der Forschung werden zu zahlreichen Zwecken Proben mittels Elektronenspinresonanz (ESR) untersucht, beispielsweise um ihre Zusammensetzung oder Konzentration an Radikalen zu analysieren. Für derartige Untersuchungen muss die Probe mit einem starken Magnetfeld beaufschlagt werden. Dieses dient dazu, die Entartung verschiedener Spinzustände aufzuheben. Die verschiedenen Spinzustände werden dadurch zu verschiedenen Energieniveaus aufgespalten. Bei der Aufnahme eines ESR-Spektrums werden dann Übergänge zwischen diesen Energieniveaus untersucht.

Hierzu sind nach dem Stand der Technik resistive Elektromagnete bekannt. Diese Magnete wiegen etwa 2 Tonnen. Supraleitende Elektromagnete (Kryomagnete) wiegen nur etwa 500 kg, jedoch müssen sie ständig mit flüssigem Stickstoff und gegebenenfalls auch Helium unter die Sprungtemperatur des verwendeten Supraleiters gekühlt werden.

In der Umwelttechnik oder beispielsweise auch der Archäologie werden häufig Messungen am lebenden Objekt und somit in der freien Natur notwendig. Bisher konnten ESR-Messungen in der Umwelt nur erschwert durchgeführt werden, da die ESR-Geräte und hier insbesondere die Vorrichtungen zur Beaufschlagung der Probe mit dem notwendigen Magnetfeld nur unter großem Aufwand zu einem Einsatzort in der Natur transportiert und dort betrieben werden können.

Es ist daher die Aufgabe der Erfindung, eine Vorrichtung zu schaffen, die ESR-Messungen in der freien Natur ermöglicht. Die Vorrichtung soll transportabel sein und ein geringes Gewicht aufweisen.

### Aufgabe und Lösung

Diese Aufgabe wird erfindungsgemäß gelöst durch ein Magnetsystem gemäß Hauptanspruch.

Weitere vorteilhafte Ausgestaltungen ergeben sich aus den darauf rückbezogenen Unteransprüchen.

### Gegenstand der Erfindung

Im Rahmen der Erfindung wurde ein Magnetsystem entwickelt, welches einen Probenraum und mindestens zwei im wesentlichen konzentrische, bevorzugt konzentrisch um den Probenraum angeordnete Stapelungen von mindestens zwei Ringen umfasst. Die Ringe weisen magnetisierte Bereiche auf, und die Stapelungen sind gegeneinander drehbar gelagert.

Unter einer Stapelung im Sinne dieser Erfindung wird insbesondere eine Aneinanderreihung von Ringen verstanden, deren Mittelpunkte nicht zusammenfallen, jedoch im Wesentlichen auf einer gemeinsamen, zu den von den Ringen eingeschlossenen Flächen vorzugsweise senkrechten Achse liegen. Dieser Begriff ist zu unterscheiden von einer konzentrischen Anordnung von Objekten (Ringen oder Stapelungen) mit verschiedenen Radien.

Die Erfindung umfasst ausdrücklich auch Magnetsysteme mit mehr als zwei, insbesondere mit drei Stapelungen, wobei auch nicht alle Stapelungen gegeneinander drehbar gelagert sein müssen. Im Speziellen Beschreibungsteil ist ein Ausführungsbeispiel mit drei Stapelungen angegeben, von denen zwei gemeinsam gegen die dritte drehbar gelagert sind.

Es wurde erkannt, dass durch eine Drehung der Stapelungen gegeneinander das Magnetfeld im Probenraum in genügend weiten Grenzen und zugleich auch in genügend kleinen Schritten variiert werden kann. Die an einem gegebenen Ort im Probenraum durch die beiden Stapelungen bewirkten Einzelfelder addieren sich vektoriell zum Gesamtfeld an diesem Ort. Insbesondere können die Einzelfelder gleich ausgerichtet sein, was das Gesamtfeld maximiert. Die Einzelfelder können aber auch gegeneinander ausgerichtet sein, was das Gesamtfeld minimiert und im Idealfall fast auslöscht.

Der Vorteil gegenüber dem Stand der Technik besteht darin, dass für eine Variation des Magnetfelds im Probenraum kein Eingriff in die magnetisierten Bereiche erforderlich ist. Somit können die magnetisierten Bereiche insbesondere Permanentmagnete sein. Nach dem Stand der Technik lässt sich der Probenraum nur mittels eines normal- oder supraleitenden Elektromagneten mit einem in weiten Grenzen variablen Magnetfeld beaufschlagen. Pro Tesla Feld im Probenraum ist bei normalleitenden (resistiven) Elektromagneten ein Eigengewicht von etwa 1500 kg und bei supraleitenden (Kryo-) Magneten ein Eigengewicht von etwa 200 kg zu veranschlagen. Normalleitende Elektromagnete benötigen darüber hinaus für die Aufrechterhaltung des Magnetfelds ständig große Mengen Strom, dessen Verlustleistung in der Regel eine Wasserkühlung erforderlich macht. Supraleitende Elektromagnete benötigen einen steten Nachschub an flüssigem Stickstoff und Helium und müssen aufwändig gegen die Umgebung wärmeisoliert sein. Zum Ein- und Ausfahren des Magnetfeldes wird darüber hinaus eine Stromquelle benötigt. Das erfindungsgemäße Magnetsystem wiegt pro Tesla Magnetfeld im Probenraum mit 250 kg etwa so viel wie ein Kryomagnet, ist aber nicht auf die Zufuhr von Kühlmitteln angewiesen und benötigt keine Stromquelle zur Änderung des Magnetfelds im Probenraum.

Für den mobilen Einsatz weist daher das erfindungsgemäße Magnetsystem, das das Magnetfeld mit Permanentmagneten erzeugen und aufrechterhalten kann, deutliche Vorteile auf. Das im Speziellen Beschreibungsteil angeführte Ausführungsbeispiel wiegt etwa 75 kg und kann im Probenraum ein Magnetfeld von bis zu 0,3 Tesla erzeugen. Ein normalleitender Elektromagnet für Felder bis zu 0,6 Tesla wiegt dagegen bereits 2100 kg und setzt bis zu 12 kW elektrische Leistung in durch Wasserkühlung abzuführende Wärme um.

In einer besonders vorteilhaften Ausgestaltung der Erfindung bestehen die Ringe aus einem nicht ferromagnetischen Material und umfassen Permanentmagnete. Dies führt zu einer erheblichen Gewichtsersparnis im Vergleich zu Ringen, die vollständig aus einem ferromagnetischen Material bestehen. Zudem kann die Magnetfeldverteilung eines Rings über die Positionierung der Permanentmagnete sehr genau eingestellt werden. Sind vorzugsweise alle Permanentmagnete im Rahmen ihrer Fertigungstoleranzen identisch, kann die Genauigkeit der Magnetfeldverteilung noch weiter gesteigert werden. Die Feldstärken nominell identischer Permanentmagnete weisen eine Streuung um den Nominalwert von typischerweise 1 bis 10 Prozent auf. Werden aus einer großen Stichprobe von Magneten nur diejenigen ausgewählt, deren Feldstärken dem Nominalwert am nächsten kommen, weicht die Magnetfeldverteilung des Rings am wenigsten von der gewünschten Verteilung ab.

Jeder Permanentmagnet sollte ein Koerzitivfeld aufweisen, das größer ist als das an seinem Ort durch die restlichen Permanentmagnete maximal erzeugbare lokale Magnetfeld. Dann kann seine Magnetisierungsrichtung sich unabhängig davon, welches Magnetfeld im System eingestellt wird, nicht ungewollt ändern. Wird die Magnetisierung eines der Permanentmagnete verändert oder gar umgepolt, verschlechtert dies dauerhaft die Qualität, insbesondere die Homogenität, des im System erzeugten Magnetfelds.

Die Permanentmagnete sind vorteilhaft in einer Halbach-Geometrie und hier insbesondere in einer Mandhala-Geometrie angeordnet. Vorzugsweise sind dann auch alle Permanentmagnete im Rahmen ihrer Fertigungstoleranzen identisch. Mit derartigen Geometrien lässt sich für diese Systeme die größtmögliche Homogenität des Magnetfelds in der Ebene eines jeden Ringes erreichen.

Eine weitere vorteilhafte Ausgestaltung der Erfindung bewirkt eine gute Homogenität des Magnetfelds im Probenraum auch in der dritten Raumdimension, entlang der gemeinsamen Drehachse der Stapelungen. In dieser Ausgestaltung sind die Abstände der einzelnen Ringe zur Mitte der Stapelung symmetrisch um die Mitte der Stapelung verteilt. Die Ringe sind dann spiegelsymmetrisch zu der zu den Ringen parallelen Ebene angeordnet, die die Stapelung in zwei Hälften teilt.

Idealerweise weisen die Stapelungen derartige Abstände zwischen jeweils benachbarten Ringen auf, bei dem die relative Variation ΔB/B des Magnetfelds B entlang der gemeinsamen Drehachse der Stapelungen höchstens 10⁻³, bevorzugt höchstens 10⁻⁴, idealerweise höchstens 10⁻⁶ beträgt. Diese Abstände lassen sich iterativ in einer zumutbaren Anzahl Versuche unter Messung der Magnetfeldverteilung im Probenraum bestimmen. Sie lassen sich aber auch näherungsweise rechnerisch bestimmen. Dazu werden in einem mathematischen Modell idealisierte Ringe entlang einer gemeinsamen, zu den durch die Ringe eingeschlossenen Flächen normalen Achse gestapelt, wobei die Abstände zwischen den Ringen und gegebenenfalls weitere Eigenschaften der Ringe freie Parameter sind. Es wird von der vereinfachenden Annahme ausgegangen, dass die Magnetisierungen der Ringe sich nicht gegenseitig beeinflussen; stattdessen addieren sich im Probenraum die Magnetfelder der Ringe ungestört. Durch Parameteroptimierung werden die Werte für die Parameter bestimmt, bei denen die Variation des Magnetfelds entlang der gemeinsamen Drehachse in diesem Modell minimal wird. Anhand der so bestimmten Abstände und weiteren Eigenschaften der Ringe wird die wirkliche Vorrichtung gebaut. Auf Grund unvermeidlicher Abweichungen zwischen dem mathematischen Modell und den wirklichen Stapelungen kann noch eine experimentelle Nachjustage auf der Basis von Messungen der Magnetfeldverteilung im Probenraum erforderlich werden. Eine größtmögliche Homogenität des Magnetfelds ist insbesondere für Magnetresonanzuntersuchungen von Proben vorteilhaft.

Typische Werte für die Abstände zwischen den Ringen einer Stapelung liegen zwischen 10 und 20 mm bei einem Ringradius von etwa 110 mm.

Verfolgt man die Entwicklung des Magnetfelds auf einem Weg durch eine Stapelung entlang der gemeinsamen Drehachse der Stapelungen, so springt das Magnetfeld in der Regel beim Eintritt in den Probenraum nicht von Null auf den homogenen Wert, sondern baut sich stetig auf. Erfahrungsgemäß weist das Magnetfeld einer Stapelung jeweils in den beiden äußersten Ringen an jedem Ende einer Stapelung deutliche Inhomogenitäten auf, bevor es in den restlichen Ringen im Inneren der Stapelung den homogenen Wert erreicht und beibehält. Am anderen Ende der Stapelung klingt das Magnetfeld in den letzten beiden Ringen der Stapelung dann wieder ab. Gleiches gilt für ein komplettes, aus mehreren konzentrisch angeordneten Stapelungen zusammengesetztes Magnetsystem.

In einem Ausführungsbeispiel des Magnetsystems wurden entsprechend dieser Beobachtung bei der Optimierung der Abstände zwischen den Ringen einer Stapelung jeweils die beiden äußersten Ringe an jedem Ende der Stapelung in festen Positionen belassen und nur die Abstände zwischen den restlichen, inneren Ringen optimiert. Vorzugsweise enthält eine Stapelung immer eine gerade Anzahl solcher innerer Ringe, insgesamt also 2+2n+2 Ringe mit einer ganzen Zahl n, jedoch sind auch Ausführungsformen möglich, die 2+n+2 Ringe aufweisen. Dabei teilt die Stapelmitte dann den mittleren Ring in zwei Hälften, die jeweils wieder einen geschlossenen Ring darstellen.

Vorteilhaft weist das Magnetsystem mindestens eine Antriebseinheit zur Drehung der Stapelungen gegeneinander auf. Dann lässt sich das Magnetfeld im Probenraum insbesondere bei länger andauernden Messreihen automatisch durchstimmen (sweepen). Damit möglichst genau ein vorgegebener Wert für die Stärke des Magnetfelds eingestellt werden kann, ist als Antriebseinheit insbesondere ein Schrittmotor vorteilhaft.

Als verbindendes Element zwischen der Antriebseinheit und mindestens einer Stapelung ist insbesondere ein Zahnriemen vorteilhaft. Auf Grund ihres Eigengewichts hat eine Stapelung ein großes Trägheitsmoment. Sowohl beim Anfahren als auch beim Anhalten der Drehung verringert ein Zahnriemen auf Grund seiner Elastizität das maximale Drehmoment, mit dem die Antriebseinheit beaufschlagt wird. Zudem rutscht ein Zahnriemen beim Anhalten nicht durch.

In einer besonders vorteilhaften Ausgestaltung der Erfindung ist das Magnetsystem in einer Apparatur zur Messung von Resonanzeffekten und hier insbesondere in einer Elektronenspinresonanz-Apparatur angeordnet. Dann kann es dazu genutzt werden, um im mobilen Einsatz die Zusammensetzungen oder auch Konzentrationen an Radikalen insbesondere von im Feld gewonnenen Umweltproben zu analysieren.

### Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:
- Figur 1:: Ausführungsbeispiel des erfindungsgemäßen Magnetsystems.
- Figur 2:: Explosionsdarstellung der obersten Lage der Stapelungen aus Figur 1.
- Figur 3:: Ausführungsbeispiel aus Figur 1, erweitert um Antriebe und um eine Halterung für einen Kryostaten zur Kühlung von Proben.

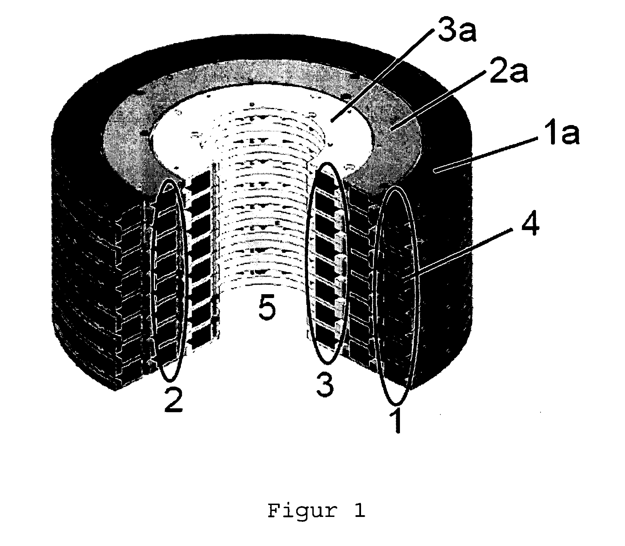

Figur 1 zeigt ein Ausführungsbeispiel des erfindungsgemäßen Magnetsystems. Dieses umfasst einen Probenraum 5 sowie drei um den Probenraum 5 angeordnete Stapelungen 1, 2 und 3, die jeweils Ringe 1a, 1b, 1c, ..., 2a, 2b, 2c, ..., beziehungsweise 3a, 3b, 3c, ..., mit magnetisierten Bereichen 4 umfassen.

Die Ringe sind in diesem Ausführungsbeispiel konzentrisch zueinander und auch konzentrisch um den Probenraum angeordnet. Dies ist nicht zwingend notwendig; es muss lediglich gewährleistet sein, dass die Ringe gegeneinander verdrehbar sind. Beispielsweise wäre es auch möglich, einen kleinen Ring exzentrisch in einem größeren Ring anzuordnen und den Innenraum des kleineren Rings als Probenraum zu wählen.

Um den erfindungsgemäßen Effekt zu erzielen, sind mindestens zwei Stapelungen von Ringen erforderlich. Die in diesem Ausführungsbeispiel gewählten drei Stapelungen sind in der Regel auch die größte technisch sinnvolle Anzahl.

Innerhalb einer Stapelung haben benachbarte Ringe in diesem Ausführungsbeispiel immer den gleichen Abstand zueinander. Dies ist ein Sonderfall der allgemeinen erfinderischen Idee, dass die Abstände der einzelnen Ringe zur Stapelmitte symmetrisch um die Stapelmitte verteilt sind.

Zwischen den Stapelungen 1, 2 und 3 sind nur sehr enge Zwischenräume vorgesehen. Die Zwischenräume müssen mindestens so groß sein, dass die Stapelungen gegeneinander frei drehbar sind und es zu keinen Kollisionen kommt. Da die Stapelungen auf Grund ihrer Masse ein hohes Trägheitsmoment aufweisen, könnten sonst an den Berührungspunkten hohe Kräfte wirken. Diese könnten beispielsweise einzelne Ringe dauerhaft verformen. Es kann daher sinnvoll sein, Gummiräder oder andere rollfähige puffernde Elemente zwischen jeweils zwei benachbarten Stapelungen einzubringen.

Ein einzelner Ring erzeugt in seinem Inneren ein Magnetfeld von maximal etwa 0,5 Tesla. Mit einer Anordnung aus drei Stapelungen können somit maximal bis etwa 1,5 Tesla im Inneren des Probenraums erzielt werden, wenn die Felder aller Ringe gleich ausgerichtet sind. Für die ESR-Spektroskopie werden im S-Band (typische Radiofrequenz 3,5 GHz) zwischen 25 und 170 Millitesla benötigt. Im X-Band (typische Radiofrequenz 9,6 GHz) werden zwischen 65 und 460 Millitesla benötigt. Im Q-Band (typische Radiofrequenz 34 GHz) werden zwischen 240 und 1650 Millitesla benötigt.

Die Ringe der einzelnen Stapelungen können im Interesse einer besseren Homogenität des Magnetfelds im Probenraum 5 auch mit magnetisierten Bereichen 4 verschiedener Stärken bestückt sein. Sinnvollerweise sind die magnetischen Bereiche 4 des innersten Rings (hier Ring 3) am stärksten magnetisiert und die des äußersten Rings (hier Ring 1) am schwächsten. Der innerste Ring 3 dient dann zur Grobeinstellung des Magnetfelds, und die äußeren Ringe 2 und 1 dienen zur Variation (Sweep) des Feldes während der Messung. Unabhängig hiervon ist es aus einer weiteren Sicht vorteilhaft, mit dem innersten Ring 3 die Grobeinstellung und mit den äußeren Ringen die Variation während der Messung durchzuführen: Da die äußeren Ringe einen größeren Umfang haben, sind bei gegebener Genauigkeit des zur Drehung verwendeten Antriebs (beispielsweise Schrittmotor) wesentlich feinfühligere Änderungen des Feldes im Probenraum 5 möglich.

Das realisierte Magnetsystem wiegt etwa 75 kg. Es ist geplant, es durch weitere Optimierung auf eine Masse von unter 50 kg zu bringen.

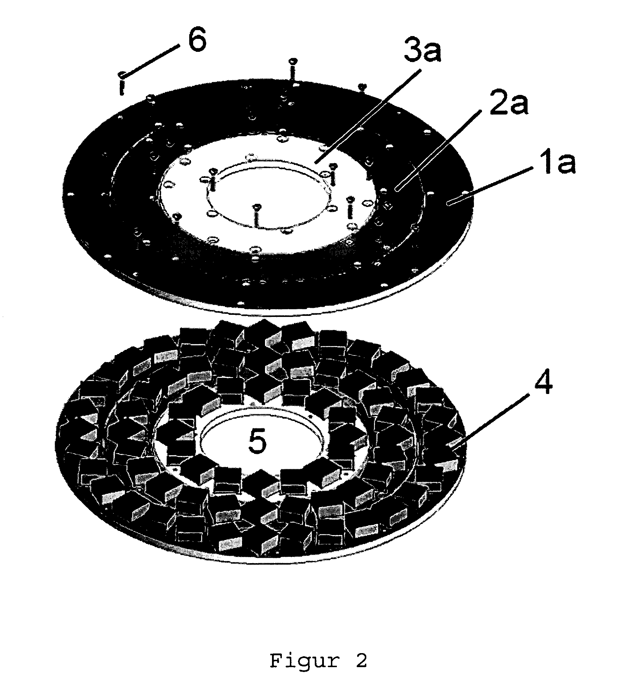

Figur 2 zeigt die oberste Lage der Stapelungen 1, 2 und 3 aus Figur 1, also die Ringe 1a, 2a, und 3a, in Explosionsdarstellung. Diese Ringe bestehen aus nichtmagnetischem Material. Das nichtmagnetische Material ist vorzugsweise ein Nichtmetall und hier beispielsweise ein Kunststoff. Bei Verwendung nichtmagnetischer, jedoch elektrisch leitender Materialien können bei einer Verdrehung der Stapelungen gegeneinander Wirbelströme induziert werden. Diese erzeugen zusätzliche Magnetfelder, die die Messung im Probenraum 5 stören können, und erwärmen außerdem die Ringe. Die Ringe bestehen jeweils aus zwei Hälften, die durch Schrauben 6 miteinander verbunden sind.

Die magnetisierten Bereiche 4 sind Permanentmagnete, die bis auf ihre Fertigungstoleranzen identisch sind. Sie sind in allen Ringen jeweils in einer Mandhala-Geometrie angeordnet; somit ist jeder Ring ein Halbachscher Dipol. Auf Grund ihrer unterschiedlichen Durchmesser unterscheiden sich die drei Ringe aber in der Anzahl der Permanentmagnete, die sie umfassen.

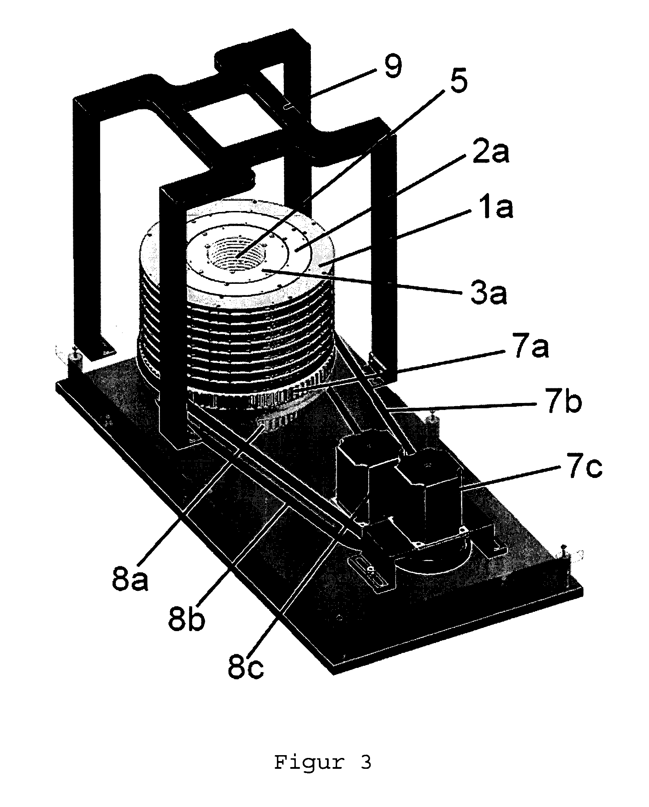

Figur 3 zeigt das Ausführungsbeispiel aus Figur 1, erweitert um Antriebe 7 und 8 und um eine Halterung 9 für einen Kryostaten. Der Antrieb 7, der die Stapelung 1 zu drehen vermag, umfasst einen an der Stapelung 1 angebrachten Zahnring 7a, einen Zahnriemen 7b und einen Schrittmotor 7c. Der Antrieb 8, der die Stapelung 2 zu drehen vermag, umfasst einen an der Stapelung 2 angebrachten Zahnring 8a, einen Zahnriemen 8b und einen Schrittmotor 8c. Die innerste Stapelung 3 wird in diesem Ausführungsbeispiel nicht gedreht. Das Magnetsystem weist eine Halterung 9 für einen Kryostaten für die Kühlung von Proben auf. Diese Halterung ist derart angeordnet, dass der gekühlte Probenkopf eines Kryostaten in den Probenraum 5 eingeführt werden kann. Damit kann das Magnetsystem auch zur Messung paramagnetischer Elektronenresonanzen (EPR) verwendet werden, die nur bei tiefen Temperaturen beobachtet werden können. Die Ringe haben in diesem Ausführungsbeispiel einen Durchmesser von etwa 22 cm.

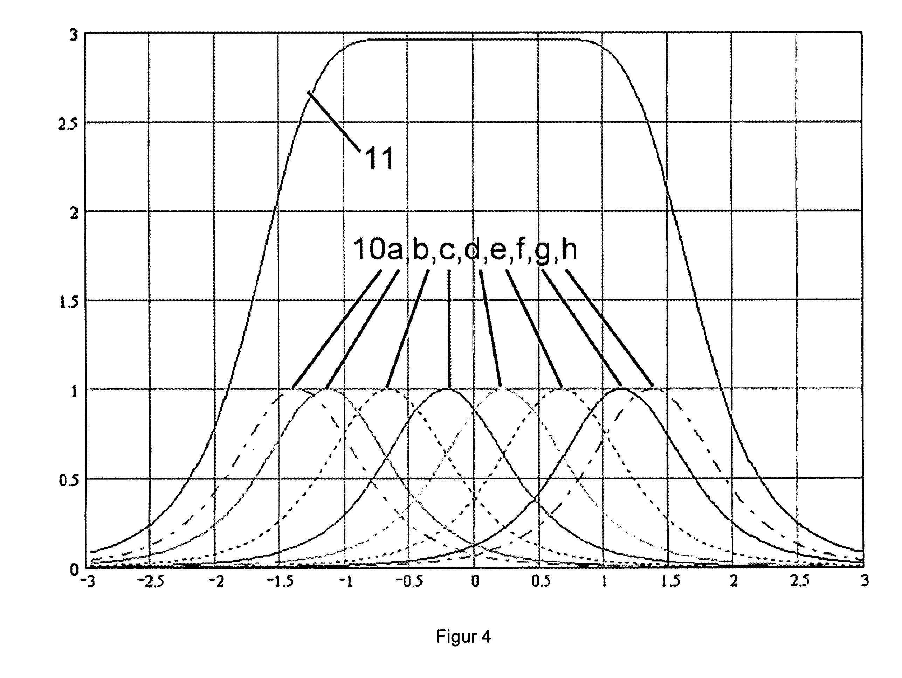

In Figur 4 sind der Aufbau und der Abfall des Magnetfelds einer Stapelung auf einem Weg durch das Magnetsystem entlang der gemeinsamen Drehachse der Stapelungen skizziert. Auf der Ordinatenachse ist der Quotient aus dem Abstand zur Mitte der Stapelung und dem Radius der Ringe der Stapelung aufgetragen. Auf der Abszissenachse ist das Magnetfeld in Einheiten des Magnetfelds eines Einzelrings aufgetragen. Aufgetragen ist der Verlauf der Magnetfelder der Einzelringe (Kurven 10a-10h, die jeweils ein Magnetfeld von 1 erreichen) sowie das gesamte aus allen Ringen resultierende Magnetfeld (Summenkurve 11, die ein Magnetfeld von beinahe 3 erreicht). Die einzelnen Ringe a bis h befinden sich jeweils dort, wo ihre zugehörige Einzelkurven 10a bis 10h ihr Maximum erreichen. Es ist klar zu erkennen, dass das Magnetfeld an beiden Enden der Stapelung im Bereich der beiden äußersten Ringe deutlich inhomogen ist. Es baut sich bis zu seinem homogenen Wert auf und behält diesen auf dem Weg durch die inneren Ringe der Stapelung bei, bis es am anderen Ende in den äußersten Ringen der Stapelung wieder abklingt.

Nachfolgend werden beispielhaft optimierte Positionen der Ringe auf der gemeinsamen Drehachse der Stapelungen angegeben, wobei die Koordinate wie auf der Ordinatenachse von Figur 4 in Einheiten des Radius normiert ist:
2+2+2 Ringe:
   -1,001; -0,654; -0,234; 0,234; 0,654; 1,001
2+4+2 Ringe:
   -1,435; -1,106; -0,675; -0,222; 0,675; 1,106; 1,435
2+6+2 Ringe:
   -1,891; -1,544; -1,125; -0,669; -0,225; 0,225; 0,669; 1,125; 1,544; 1,891

## Patentansprüche

1. Magnetsystem, umfassend einen Probenraum und mindestens zwei im wesentlichen konzentrische, bevorzugt konzentrisch um den Probenraum angeordnete Stapelungen von mindestens zwei Ringen, welche einen oder mehrere magnetisierte Bereiche aufweisen, wobei die Stapelungen gegeneinander drehbar gelagert sind.

2. Magnetsystem nach Anspruch 1, **gekennzeichnet durch** Ringe aus einem nicht ferromagnetischen Material umfassend Permanentmagnete.

3. Magnetsystem nach Anspruch 2, **gekennzeichnet durch** in einer Halbach-Geometrie angeordnete Permanentmagnete.

4. Magnetsystem nach Anspruch 3, **gekennzeichnet durch** in einer Mandhala-Geometrie angeordnete Permanentmagnete.

5. Magnetsystem nach einem der Ansprüche 1 bis 4, **gekennzeichnet durch** Stapelungen, in denen die Abstände der einzelnen Ringe zur Stapelmitte symmetrisch um die Stapelmitte verteilt sind.

6. Magnetsystem nach Anspruch 5, **gekennzeichnet durch** Abstände, bei denen die relative Variation ΔB/B des Magnetfelds B entlang der gemeinsamen Drehachse der Stapelungen höchstens 10⁻³, bevorzugt höchstens 10⁻⁴ beträgt.

7. Magnetsystem nach einem der Ansprüche 1 bis 6, **gekennzeichnet durch** mindestens eine Antriebseinheit zur Drehung der Stapelungen gegeneinander.

8. Magnetsystem nach Anspruch 7, **gekennzeichnet durch** eine Antriebseinheit, die mindestens einen Schrittmotor umfasst.

9. Magnetsystem nach einem der Ansprüche 7 bis 8, **gekennzeichnet durch** mindestens einen Zahnriemen als verbindendes Element zwischen der Antriebseinheit und mindestens einer Stapelung.

10. Magnetsystem nach einem der Ansprüche 1 bis 9, **dadurch gekennzeichnet, dass** es in einer Apparatur zur Messung von Magnetresonanzeffekten angeordnet ist.

11. Magnetsystem nach Anspruch 10, **gekennzeichnet durch** eine Elektronenspinresonanz-Apparatur als Apparatur.
